# EUROPÄISCHE PATENTANMELDUNG

(11) **EP 0 627 496 A2**
(43) Veröffentlichungstag der Anmeldung: **07.12.1994**
(21) Anmeldenummer: 94108300.8
(22) Anmeldetag: 30.05.1994
(51) Int. Cl.: C23C 14/22, C23C 14/16, C23C 14/02, C23C 28/02

(54) **Verfahren und Vorrichtung zur Beschichtung von Metallsubstraten, insbesondere Stahl- oder Aluminiumblechen in Bandform**

(30) Priorität: 02.06.1993 AT 1070/93
(71) Anmelder: Andritz-Patentverwaltungs-Gesellschaft m.b.H., A-8045 Graz (AT)
(72) Erfinder: Priesch, Gerhard, Ing., A-1170 Wien (AT); Goldschmied, Gerhard, Dr., A-1230 Wien (AT)
(74) Vertreter: Schweinzer, Friedrich

(57) **Zusammenfassung**

Verfahren zur Beschichtung von Metallsubstraten, insbesondere Stahl- oder Aluminiumblechen in Bandform, mit einer Deckschicht aus Metall bzw. einer Metallegierung, umfassend das Reinigen, Entfetten und Aktivieren des Substrates, wobei das Aufbringen haftfester Deckschichten auf Metallsubstrate ohne große Umweltbelastung ermöglicht sein soll. Dazu ist das Aufbringen einer Haftvermittlerschicht nach dem Aktivieren vorgesehen, sowie die Vorrichtung zur Durchführung des Verfahrens derart ausgestattet, daß in der Vakuumsektion zwischen der Aktivierungssektion 3 und der Beschichtungssektion 7 für die Aufbringung der Deckschicht eine zusätzliche Beschichtungssektion 4 für die Aufbringung der Haftvermittlerschicht vorgesehen ist.

## Beschreibung

Die Erfindung betrifft ein Verfahren zur Beschichtung von Metallsubstraten, insbesondere Stahl- oder Aluminiumblechen in Bandform, mit einer Deckschicht aus Metall bzw. einer Metallegierung, umfassend das Reinigen, Entfetten und Aktivieren des Substrates, sowie eine Vorrichtung zur Durchführung des Verfahrens, umfassend eine Eingangsschleusensektion, eine Vakuumsektion umfassend eine Aktivierungssektion und eine Beschichtungssektion für die Aufbringung der Deckschicht, sowie eine Ausgangsschleusensektion.

Die Beschichtung von Metallen mit anderen Metallen oder Metallegierungen ist eine weit verbreitete Methode, um die Basismetalle für verschiedene Verwendungszwecke besser geeignet zu machen. So wird beispielsweise in letzter Zeit verstärkt versucht, aus Gründen der Gewichtsreduktion Aluminiumlegierungen als Werkstoff für Karosserieteile von Autos einzusetzen. Im wesentlichen kommen dafür das naturharte AlMg4.5MnO.3 für die Innenteile und das aushärtbare und fließfigurenfreie AlMgO.4Si1.2 für Außenhautteile in Frage. Obwohl Al-Blech der aushärtbaren Legierung AlMg0.4Si1.2 vergleichbare Festigkeitswerte wie Stahlblech aufweist, werden diese Bleche trotz 45 % Gewichtsersparnis bis heute relativ selten im Automobilbau eingesetzt. Die Gründe dafür sind in der schlechten Phosphatierbarkeit und schlechteren Lackierbarkeit im Vergleich zu Stahl und der schlechten Punktschweißbarkeit infolge der einen hohen elektrischen Widerstand ergebenden Oxidschicht zu sehen, weshalb die genannten Al-Bleche in den bestehenden Fertigungslinien nicht verarbeitet werden können.

Es wird daher in zunehmenden Maße versucht, diese Nachteile durch das Aufbringen einer Zinkschicht zu vermeiden. Vorerst wurde dies auf elektrolytischem Wege versucht. Um eine haftfeste Schicht zu erzielen, ist es dabei notwendig, die sehr reaktive Oxidschicht vor dem Beschichten zu entfernen. In der JP-B-90050989 bzw. der JP-1047895 sind dafür Verfahren beschrieben, bei welchen mittels einer Tauchbehandlung (Zinkatverfahren) die Oxidschicht entfernt und gleichzeitig eine dünne (0,5 µm) Zinkschicht aufgebracht wird. Die eigentliche Zinkbeschichtung erfolgt anschließend auf elektrolytischem Weg. Die JP-A-03207885 bzw. die JP-A-3146688 beschreiben das elektrolytische Aufbringen einer Zinkschicht in fluoridhältigen bzw. chloridhältigen Bädern. Diese Verfahren haben aber die Nachteile, daß sie mit hohem Energieaufwand verbunden sind, die Abwässer belasten, Zinkschlamm anfällt, der entsorgt werden muß, und daß sie in vielen Fällen nur als mehrstufiger Prozeß durchführbar sind.

In letzter Zeit gewinnt das Beschichten mittels Vakuum-Bedampfungsverfahren als umweltfreundliches Verfahren zunehmend an Bedeutung. Mittels der Dampfabscheidung im Vakuum können die zuvor angegebenen Nachteile vermieden werden. Um bei diesen Verfahren haftfeste Beschichtungen zu erzielen, wird das Metallsubstrat vorzugsweise auch im Vakuum einer Vorbehandlung unterzogen, die im allgemeinen aus einer Vorwärmung des Bandes auf Temperaturen von 200 bis 300 °C besteht. Bei Aluminium als Substratwerkstoff sind infolge der Oxidschicht höhere Vorwärmtemperaturen von etwa 300 bis 400 °C notwendig. Bei Stahl sind speziell bei Zinkbeschichtungen noch höhere Temperaturen von ca. 400 bis 500 °C notwendig. Aus Gründen der Vermeidung der Reverdampfung muß das Substrat vor der Beschichtung dann abgekühlt werden, was verfahrenstechnisch mit großen Nachteilen verbunden ist. Bei aushärtbaren Aluminiumwerkstoffen tritt weiters noch eine Verschlechterung der mechanischen Eigenschaften ein.

Die Aufgabe der vorliegenden Erfindung besteht daher in einem Beschichtungsverfahren, das die oben genannten Nachteile der herkömmlichen Verfahren vermeidet und das Aufbringen haftfester Deckschichten auf Metallsubstrate ohne große Umweltbelastung ermöglicht.

Eine weitere Aufgabe besteht in einer Vorrichtung zur Durchführung eines derartigen Verfahrens.

Zur Lösung der Aufgabe ist das eingangs beschriebene Verfahren gekennzeichnet durch das Aufbringen einer Haftvermittlerschicht nach dem Aktivieren. Durch das Vorsehen einer Haftvermittlerschicht gelingt es, auf Metallsubstrate Deckschichten mit großer Haftfestigkeit mittels Vakuumverfahren und damit umweltschonend aufzubringen. So kann insbesondere Stahl oder Aluminium bzw. Aluminiumlegierung mit einer haftfesten Deckschicht, vorzugsweise einer Zinkbeschichtung, versehen werden. Das Substrat kann dabei aus einzelnen Werkstücken bestehen oder auch in Bandform vorliegen. Haftfestigkeits-, Lackier- und Punktschweißbarkeitsuntersuchungen an nach dem erfindungsgemäßen Verfahren hergestellten Werkstücken haben gezeigt, daß beispielsweise bei Zink-Deckschichten auf Aluminiumsubstraten ähnlich gute Eigenschaften erzielt werden konnten wie bei Stahlblech. Dadurch ist bei einer Anwendung auf Karosserieteile - bestehend aus Stahl- und beschichtetem Aluminiumbleche - eine Tauchphosphatierung in einem Arbeitsgang möglich. Darüberhinaus erfolgt die Aufbringung durch die Vermeidung von zu entsorgenden Schlämmen und Abwässern auf sehr umweltschonende Weise. Die Dicke der auf die Haftvermittlerschicht aufgebrachten Deckschicht kann in sehr weitem Maße variieren und beispielsweise für Zink zwischen 0,1 bis 20 µm, vorzugsweise 2 bis 7 µm, betragen, wobei dies bei bandförmigem Substrat sowohl für die einseitige als auch die beidseitige Beschichtung gilt.

Gemäß einer Variante des erfindungsgemäßen Verfahrens erfolgt die Aktivierung des Substrates durch Vorwärmen.

Gemäß einer weiteren Variante erfolgt die Aktivierung des Substrates durch lonenätzen, gegebenenfalls nach einem Vorwärmen des Substrates.

Vorteilhafterweise wird eine Haftvermittlerschicht aus Aluminium aufgebracht. Dies hat bei Stahlsubstraten den zusätzlichen Vorteil, daß deren Korrosionsschutz erhöht wird, da die Deckschicht einerseits besser haftet und gleichzeitig die Aluminiumschicht selbst einen Korrosionsschutz darstellt.

Um die mechanischen Eigenschaften des Substratwerkstoffes nicht zu verändern, insbesondere bei Aluminiumsubstraten, ist gemäß einem weiteren Merkmal der Erfindung vorgesehen, daß das Aufbringen der Haftvermittlerschicht bei Temperaturen von maximal 300 °C, vorzugsweise 250 °C, insbesondere weniger als 140 °C, vorzugsweise weniger als 100 °C, erfolgt und in den nachfolgenden Verfahrensschritten eine Temperatur von 300 °C, vorzugsweise 190 °C, nicht überschritten wird. Selbst bei Aluminiumsubstraten betragen deren Temperaturen nach dem Aufbringen einer Zinkschicht - je nach Blechdicke und Auflagenstärke - maximal 300 °C, wodurch die Reverdampfung der aufgebrachten Beschichtung vermieden werden kann, vorzugsweise sogar nur zwischen 160 und 190 °C.

Die Haftvermittlerschicht wird vorteilhafterweise bis zu einer Dicke von 0,1 bis 2 µm, vorzugsweise 0,3 µm aufgebracht.

Das Aufbringen der Haftvermittlerschicht geschieht gemäß einem weiteren Merkmal der Erfindung vorteilhafterweise durch Sputtern.

Selbstverständlich kann das Metallsubstrat beidseitig mit der Haftvermittlerschicht und der Deckschicht versehen werden.

Die Vorrichtung zur Beschichtung von Metallsubstraten im Vakuum ist erfindungsgemäß dadurch gekennzeichnet, daß in der Vakuumsektion zwischen der Aktivierungssektion und der Beschichtungssektion für die Aufbringung der Deckschicht eine zusätzliche Beschichtungssektion für die Aufbringung der Haftvermittlerschicht vorgesehen ist. Es besteht die Möglichkeit, die Vorrichtung für die Beschichtung einzelner Werkstücke oder auch für die Beschichtung von in Bandform vorliegendem Substrat einzusetzen und auszulegen.

Zur beidseitigen Beschichtung eines Werkstückes oder Bandes sind vorteilhafterweise zumindest zwei Verdampfertiegel, enthaltend das Material für die Haftvermittlerschicht, auf einander gegenüberliegenden Seiten des Metallsubstrates vorhanden.

Vorteilhafterweise ist zur Erwärmung des Materials in den Verdampfertiegeln zumindest eine Einrichtung zur Erzeugung eines Elektronenstrahles vorgesehen.

Dabei kann eine apparative Vereinfachung dadurch erzielt werden, daß Einrichtungen zur Erzeugung lediglich eines Elektronenstrahles und Einrichtungen zur taktweisen bzw. oszillierenden Ablenkung des einen Elektronenstrahles in jeweils einen der Verdampfertiegel vorgesehen sind.

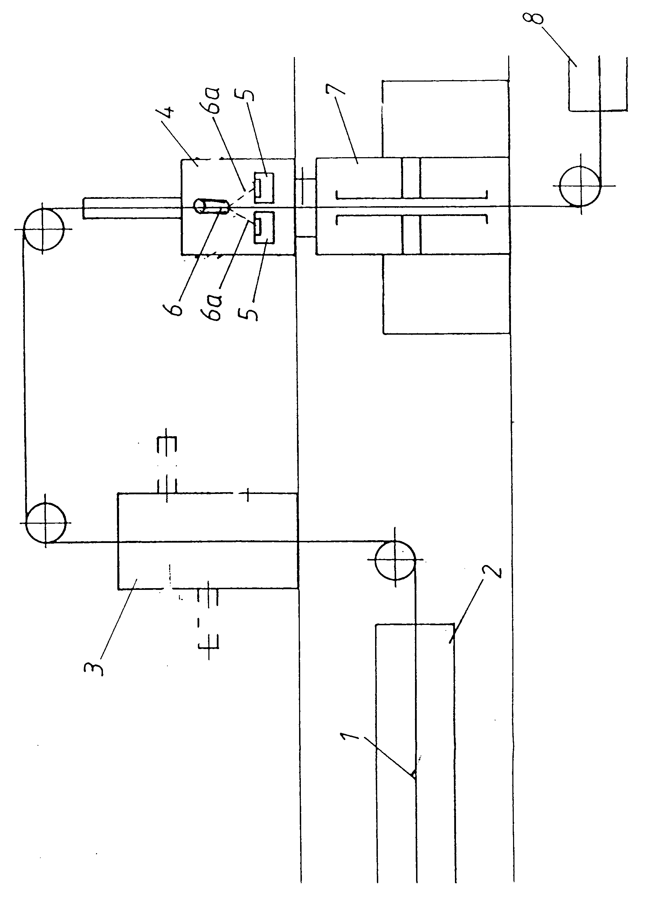

In der nachfolgenden Beschreibung soll die Erfindung unter Bezugnahme auf die beiliegende Zeichnung näher erläutert werden. Die Zeichnung zeigt eine schematische Darstellung einer Vorrichtung zur Beschichtung eines bandförmigen Metallsubstrates gemäß der vorliegenden Erfindung.

Das Metallband 1 wird durch die Eingangsschleusensektion 2 in den Vakuumbereich der Anlage gebracht. Dabei wird die Feinreinigung und bzw. oder Aktivierung des Bandes in einem Druckbereich von 10⁻¹ bis 10⁻⁴ mbar, vorzugsweise 10⁻³ mbar, durchgeführt. Das Band 1 gelangt zu einer Vorwärmstation 3 und danach zur Beschichtungssektion 4 für die Aufbringung einer Haftvermittlerschicht auf dem Band 1. die Beschichtungssektion 4 enthält auf jeder Seite des Bandes 1 je einen Verdampfertiegel 5, der das auf das Band 1 aufzubringende Metall bzw. die Metallegierung enthält. Die Beschichtungssektion 4 enthält weiters Einrichtungen 6 zur Erzeugung zumindest eines Elektronenstrahles 6a. Vorzugsweise wird lediglich ein einzelner Elektronenstrahl erzeugt und dieser durch weitere - nicht dargestellte - Einrichtungen abwechselnd auf die beiden Verdampfertiegel 5 gerichtet. Anstelle durch den Elektronenstrahl könnte das Material in den Tiegeln 5 auch durch Widerstandsheizungen erwärmt werden.

Schließlich gelangt das mit der Haftvermittlerschicht versehene Band 1 in die Beschichtungssektion 7 für die Aufbringung der Deckschicht. Diese kann gleich wie die Beschichtungssektion 4 oder auch unterschiedlich zu dieser aufgebaut sein. Das Vakuum in der Sektion 7 und vorzugsweise auch in der Sektion 4 beträgt 10⁻² bis 10⁻⁴ mbar, vorzugsweise 10⁻³ mbar.

Durch die Ausgangsschleusensektion 8 tritt das vollständig mit Haftvermittler- und Deckschicht beschichtete Band 1 wieder aus der erfindungsgemäßen Vorrichtung aus.

### Ausführungsbeispiel 1:

Bleche der Aluminiumlegierung AlMg0.4Si1.2, die Blechstärke betrug dabei 1 mm, wurden durch Entfetten in konventionellen Entfettungsbädern, durch Vorwärmen und Aktivieren der Oberfläche mittels lonenätzen vorbereitet. Anschließend wurde die Haftvermittlerschicht, hier eine Aluminiumschicht, und schließlich eine Deckschicht aus Zink aufgebracht. Als Verdampferquelle wurde dabei ein Elektronenstrahl eingesetzt. Die Verfahrensparameter sind der folgenden Tabelle zu entnehmen (die Temperaturen gelten dabei immer zumindest für das Ende des jeweiligen Verfahrensschrittes):

| **Verfahrensschritt** | **Verfahrensparameter** | **Resultat** |
|---|---|---|
| Entfetten | 40 g/l NaOH, 20 g/1 Na₃PO₄ + Netzmittel, Badtemperatur: 90^{o}C | fettfreie Oberfläche |
| Vorwärmen mittels Elektronenstrahl | Strahlleistung P = 8 kW, Vorwärmzeit: 30 s, Substrattemperatur: 90^{o} C | Ablösen der Wasserhaut |
| magnetfeldunterstütztes Ionenätzen | Ätzleistung 2 kW, Ätzzeit 180 s, Substrattemperatur: 140 °C | aktivierte Oberfläche |
| Al - Bedampfung | Strahlleistung P = 80 kW, Zeit 30 s, Substrattemperatur:ca 150 -160 °C | Haftvermittlerschicht 0,3 µm |
| Zn - Bedampfung | Strahlleistung P = 22 kW, Zeit 60 s, Substrattemperatur: ca 180 °C | Deckschicht 5 µm |

### Ausführungsbeispiel 2:

Ein Stahlband der Stärke 0,65 mm wurde ähnlichen Behandlungsschritten unterworfen wie das Aluminiumsubstrat von Ausführungsbeispiel 1. Die Verfahrensparameter waren:

| **Verfahrensschritt** | **Verfahrensparameter** | **Resultat** |
|---|---|---|
| Vorwärmen mittels Elektronenstrahl | Strahlleistung P = 8 kW, Vorwärmzeit: 90 s, Substrattemperatur: 221 °C | Ablösen d. Wasserhaut u.Aktivierung d.Oberfläche |
| Al - Bedampfung | Strahlleistung P = 80 kW, Zeit 30 s, Substrattemperatur: 238 °C | Hattvermittlerschicht 0,3 µm |
| Zn - Bedampfung | Strahlleistung P = 22 kW, Zeit 60 s, Substrattemperatur: 242 °C | Deckschicht 5µm |

## Patentansprüche

1. Verfahren zur Beschichtung von Metallsubstraten, insbesondere Stahl- oder Aluminiumblechen in Bandform, mit einer Deckschicht aus Metall bzw. einer Metallegierung, umfassend das Reinigen, Entfetten und Aktivieren des Substrates, sowie die nachfolgende Aufbringung der Deckschicht mittels Dampfabscheidung im Vakuum, gekennzeichnet durch das Aufbringen einer Haftvermittlerschicht nach dem Aktivieren.

2. Verfahren nach Anspruch 1, dadurch gekennzeichnet, daß die Aktivierung des Substrates durch Vorwärmen erfolgt.

3. Verfahren nach Anspruch 1, dadurch gekennzeichnet, daß die Aktivierung des Substrates durch lonenätzen, gegebenenfalls nach einem Vorwärmen des Substrates, erfolgt.

4. Verfahren nach einem der Ansprüche 1 bis 3, dadurch gekennzeichnet, daß eine Haftvermittlerschicht aus Aluminium aufgebracht wird.

5. Verfahren nach einem der vorangehenden Ansprüche, dadurch gekennzeichnet, daß das Aufbringen der Haftvermittlerschicht bei Temperaturen von maximal 300 °C, vorzugsweise 250 °C, insbesondere weniger als 140 °C, vorzugsweise weniger als 100 °C, erfolgt und in den nachfolgenden Verfahrensschritten eine Temperatur von 300 °C, vorzugsweise 190 °C, nicht überschritten wird.

6. Verfahren nach einem der Ansprüche 1 bis 5, dadurch gekennzeichnet, daß die Haftvermittlerschicht bis zu einer Dicke von 0,1 bis 2 µm, vorzugsweise 0,3 µm, aufgebracht wird.

7. Verfahren nach einem der Ansprüche 1 bis 6, dadurch gekennzeichnet, daß die Haftvermittlerschicht durch Sputtern aufgebracht wird.

8. Verfahren nach einem der vorangehenden Ansprüche, dadurch gekennzeichnet, daß das Metallsubstrat beidseitig mit der Haftvermittlerschicht und der Deckschicht versehen wird.

9. Vorrichtung zur Beschichtung von Metallsubstraten im Vakuum, umfassend eine Eingangsschleusensektion, eine Vakuumsektion umfassend eine Aktivierungssektion (3) und einer Beschichtungssektion (7) für die Aufbringung der Deckschicht, sowie eine Ausgangsschleusensektion (8), dadurch gekennzeichnet, daß in der Vakuumsektion zwischen der Aktivierungssektion (3) und der Beschichtungssektion (7) für die Aufbringung der Deckschicht eine zusätzliche Beschichtungssektion (4) für die Aufbringung der Haftvermittlerschicht vorgesehen ist.

10. Vorrichtung nach Anspruch 9, dadurch gekennzeichnet, daß zumindest zwei Verdampfertiegel (5), enthaltend das Material für die Haftvermittlerschicht, auf einander gegenüberliegenden Seiten des Metallsubstrates (1) vorhanden sind.

11. Vorrichtung nach Anspruch 10, dadurch gekennzeichnet, daß zur Erwärmung des Materials in den Verdampfertiegeln (5) zumindest eine Einrichtung (6) zur Erzeugung eines Elektronenstrahles (6a) vorgesehen ist.

12. Vorrichtung nach Anspruch 11, dadurch gekennzeichnet, daß Einrichtungen (6) zur Erzeugung lediglich eines Elektronenstrahles (6a) und Einrichtungen zur taktweisen bzw. oszillierenden Ablenkung des einen Elektronenstrahles (6a) in jeweils einen der Verdampfertiegel (5) vorgesehen sind.
